(19) **Europäisches Patentamt**

**European Patent Office**

**Office européen des brevets**

(11) **EP 1 058 451 B1**

(12) **EUROPEAN PATENT SPECIFICATION**

(45) Date of publication and mention
of the grant of the patent:
**19.07.2006 Bulletin 2006/29**

(51) Int Cl.:
***H04N 5/455*** *(2006.01)* *H03D 1/22* *(2006.01)*

(21) Application number: **99830330.9**

(22) Date of filing: **31.05.1999**

(54) **Digital AM demodulator, particularly for demodulating TV signals**

Digitaler AM-demodulator , insbesondere für die Demodulation von Fernsehsignalen

Démodulateur d'amplitude numérique , notamment pour la démodulation de signaux de télévision

(84) Designated Contracting States:
**DE FR GB IT**

(43) Date of publication of application:
**06.12.2000 Bulletin 2000/49**

(73) Proprietor: **STMicroelectronics S.r.l.**
**20041 Agrate Brianza (Milano) (IT)**

(72) Inventors:
• **Della Torre, Luigi**
**20035 Lissone (IT)**
• **Ronchi, Marco**
**20040 Cavenago Brianza (IT)**
• **Vitali, Andrea**
**24100 Bergamo (IT)**

(74) Representative: **Modiano, Micaela Nadia et al**
**Dr. Modiano & Associati S.p.A.**
**Via Meravigli 16**
**20123 Milano (IT)**

(56) References cited:
**EP-A- 0 683 609     EP-A- 0 769 873**
**WO-A-98/12836       DE-A- 19 538 935**
**DE-A- 19 720 766     DE-C- 4 444 870**
**FR-A- 2 765 428       US-A- 5 694 419**
**US-A- 5 731 848       US-A- 5 809 088**

**Description**

The present invention relates to a digital AM demodulator. More particularly, the invention relates to a high-frequency digital AM demodulator particularly adapted for demodulating TV signals in the PAL-NTSC-SECAM formats, starting from a medium-frequency sampled signal (originating from a tuner), which can be integrated in a digital video processing unit.

It is known that in order to demodulate, for example, a TV signal starting from a medium-frequency sampled signal originating from the tuner there is provided an analog demodulator arranged downstream of the tuner; its output is a signal which is demodulated in an audio demodulator in order to obtain an audio signal and a video signal which is split into a luminance signal and a chrominance signal.

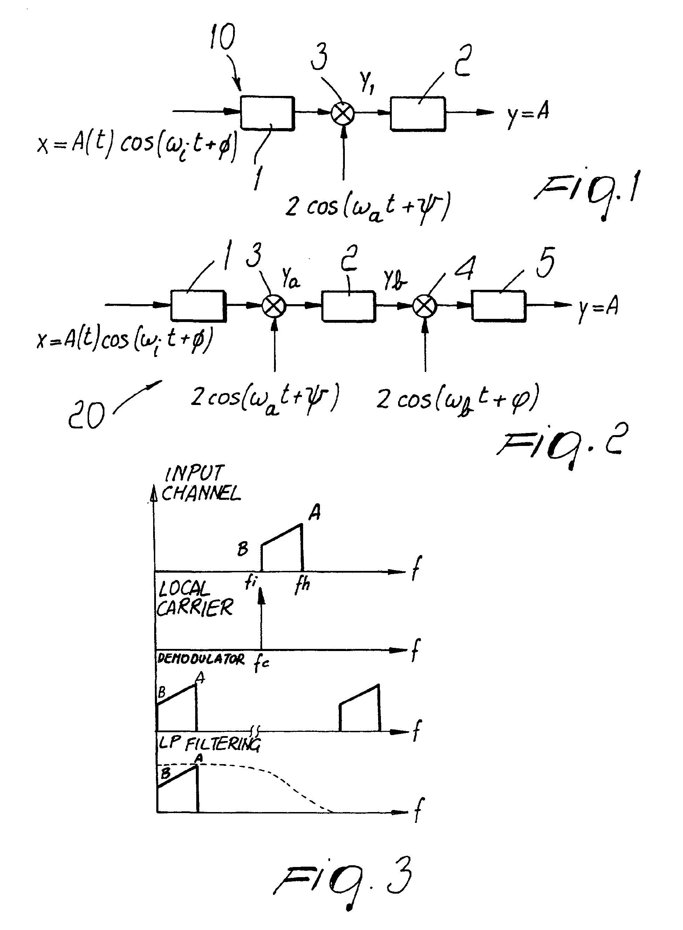

We now consider a known AM demodulator, whose block diagram is shown in Figure 1; said demodulator is constituted by an input filter 1 and by a low-pass filter 2 arranged in a cascade configuration, in which the filter 1 is fed with an input signal and whose output is fed to a multiplier 3 which in turn receives in input a local carrier signal.

Assuming, therefore, that a local carrier, designated by "carrier", is available whose value is

$$\text{carrier} = 2\,cos(\omega_a t + \psi)$$

and bearing in mind that according to the trigonometric addition and subtraction formulas

$$cos(\alpha) + cos(\beta) = cos\left(\frac{\alpha+\beta}{2}\right) \cdot cos\left(\frac{\alpha-\beta}{2}\right)$$

the beat between the carrier (carrier) and the received signal x(t) produces the demodulation of A(t) by virtue of the following relations:

$$\text{input } x = A(t) \cdot cos(\omega_i t + \phi)$$

$$\text{carrier} = 2 \cdot cos(\omega_a t + \psi)$$

$$y_t = \text{input} \cdot \text{carrier}$$

$$y_t = 2 \cdot A(t) \cdot cos(\omega_i t + \phi) \cdot cos(\omega_a t + \psi) =$$

$$= A(t) \cdot cos[(\omega_i + \omega_a)t + (\phi + \psi)] + cos[(\omega_i-\omega_a)t + (\phi - \psi)]$$

After multiplication, one obtains a spectrum composed of two components, as shown in Figure 3: one is modulated around the pulse $(\omega_i - \omega_a)$, the other one is modulated around the pulse $(\omega_i + \omega_a)$.

If the higher-frequency component is removed with a low-pass filter and the condition $\omega_i = \omega_a$ is set, one obtains:

$$y = A(t) \cdot cos[(\omega_i-\omega_a)t + (\phi - \psi) = A(t) \cdot cos(\phi - \psi)t = A(t) \cdot k(t)$$

$$\omega_i = \omega_a$$

$$|k| <= 1$$

Since the coefficient k has a modulus of 1 or less, in order to also provide the demodulated channel with the maximum energy level (SNR = max, where SNR is the signal/noise ratio), it is necessary to set:

$$\omega_a = \omega_i \quad => \quad y = A(t) \cdot cos(\phi - \psi)$$

$$\phi = \psi \quad => \quad y = A(t)$$

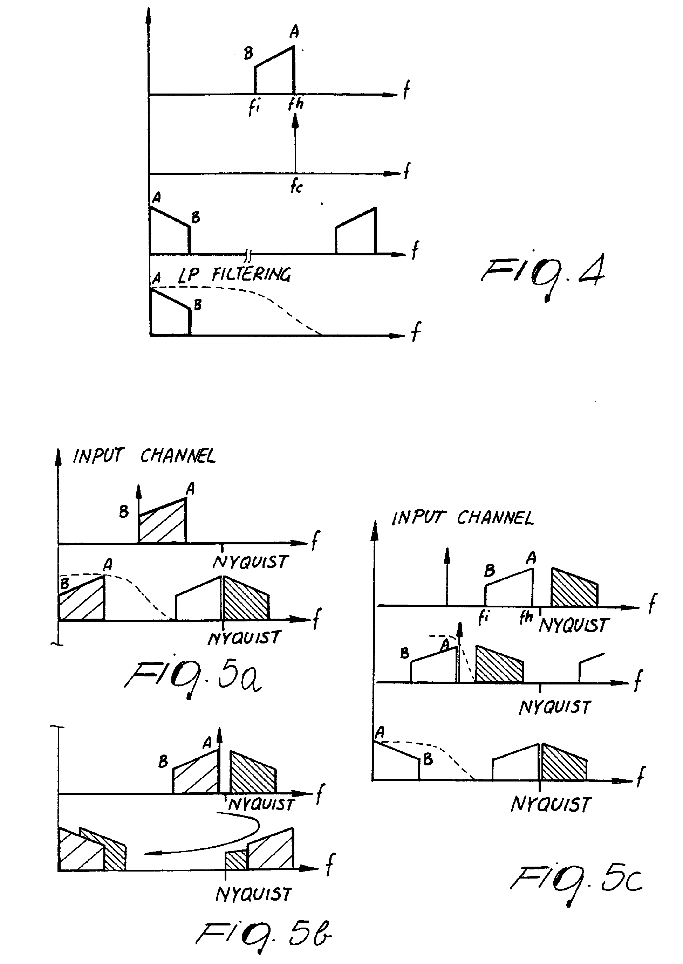

Using the same reasoning and with reference to Figures 3 and 4, it can be easily demonstrated that it is possible to perform baseband demodulation of the transposed input channel or of its exact symmetrical counterpart by acting on the position of the pulse of the local carrier. If $f_c = f_i$, the baseband spectrum is exactly the input spectrum, whereas if $f_c = f_h$, the symmetrical spectrum is obtained.

The above is a direct demodulation. We now describe an AM demodulation achieved in two steps, i.e., with the aid of two carriers, designated by $carrier_1$ and $carrier_2$.

With reference to the diagram of Figure 2, the reference numeral 1 designates, as in the preceding case, an input filter, whereas the reference numeral 2 designates the low-pass filter and 3 is the multiplier to which the first carrier, $carrier_1$, is fed. The diagram of Figure 2 provides for a second multiplier 4 to which the second carrier, $carrier_2$, is fed and an additional low-pass filter 5 arranged downstream of the multiplier 4.

In this case, one has the following relations:

$$input = A(t) \cdot cos(\omega_i t + \phi)$$

$$carrier_1 = 2 \cdot cos(\omega_a t + \psi)$$

$$carrier_2 = 2 \cdot cos(\omega_b t + \phi)$$

$$(\omega_a + \omega_b) = \omega_i$$

$$y_a = input \cdot carrier_1$$

$$y_a = 2 \cdot A(t) \cdot cos(\omega_i t + \phi) \cdot cos(\omega_a t + \psi) =$$

$$A(t)\{cos[(\omega_i + \omega_a)t + (\phi + \psi)] \pm cos[(\omega_i - \omega_a)t + (\phi - \psi)]\}$$

After eliminating the high-frequency component $(\omega_i + \omega_a)$ one obtains:

$$y_b = A(t) \cdot cos[(\omega_i - \omega_a)t + (\phi + \psi)]$$

After the first multiplication in the first multiplier 3, the spectrum A(t) is modulated around the intermediate pulse $\omega_{int} = (\omega_i - \omega_a)$, with the initial phase $\phi_{int} = (\phi - \psi)$. The spectrum has been shifted to a lower frequency. With the second stage, shown in Figure 2, one obtains:

$$y_c = y_b \cdot carrier_2$$

$$y_c = 2 \cdot A(t) \cdot cos(\omega_{int}t + \phi_{int}) \cdot cos(\omega_b t + \varphi)$$

$$y_c = A(t) \{cos[(\omega_{int} + \omega_b)t + (\phi_{int} + \varphi)] + cos[(\omega_{int} - \omega_b)t + (\phi_{int} - \varphi)]\}$$

and after the low-pass filter 5

$$y = A(t) \cdot cos[(\omega_{int} - \omega_b)t + (\phi_{int} - \varphi)]$$

The conditions under which the input signal A(t) is correctly baseband-demodulated are:

$$\omega_i = (\omega_a + \omega_b) \quad \text{condition 1}$$

$$\phi = (\psi + \varphi) \quad \text{condition 2}$$

It can be noted that both the pulse $\omega_i$ and the phase $\phi$ can be distributed at will between the two local carriers, carrier$_1$ and carrier$_2$.

Accordingly, the following problems arise in the design of a demodulator, particularly of the digital type.

Since at the output of a tuner the phase $\phi$ is not known in advance and the medium-frequency spectrum has a band shift which can vary by a few hundred kHz with respect to its nominal value (for a video tuner the band is 33-38.9 MHz +/- 100 kHz), the need for a PLL is evident, for analog recovery signals, in order to extract $\omega_i$ in phase with the received signal $\phi$. For medium-high frequencies ($f$>20MHz), digital PLLs are typically more onerous than analog equivalents for an equal performance and are therefore rarely used.

Another drawback is noted with discrete-time systems where t = nTs, with T equal to the sampling period. In this case, the frequency spectrum is periodic, with a period $2\pi$, and this can cause an unwanted aliasing effect during demodulation, as shown in Figure 5b.

In Figure 5a, the carrier lies at the vertex B of the input spectrum and demodulation occurs correctly. In Figure 5b, the carrier lies in the upper part of the spectrum, at the vertex A. In this case, the first two repeats of the sampled input spectrum are demodulated, distorting the band signal. This effect is not observed in the case of analog demodulation (see Figures 3 and 4) and forces two-step demodulation, as shown in Figure 5c. In this case, the first demodulation is meant to shift the input spectrum to a lower frequency and to shift the second repeat to a higher frequency. With the second demodulation, the channel is brought to baseband correctly without aliasing errors, but all this entails practically doubling the complexity of the architecture, which uses at least two multipliers and three filters, as shown in Figure 2.

Document EP-A-0 683 609 describes a device for digital demodulation of the video and audio elements of a television signal which is at intermediate frequency. It makes use of a frequency control loop and a phase locked loop (AFC/PLL), which makes it possible the obtention of the video sub-carrier at the frequency zero and with a correct phase (locked-in state).

The aim of the present invention is to provide a digital AM demodulator which does not use a PLL in a digital architecture.

Within the scope of this aim, an object of the present invention is to provide a digital AM demodulator in which recovery of the frequency and phase of the carrier is performed without resorting to a PLL.

Another object of the present invention is to provide a digital AM demodulator which can be easily integrated in digital video decoders.

Another object of the present invention is to provide a digital AM demodulator in which the complexity of the circuit and the occupied area are reduced with respect to known solutions.

Another object of the present invention is to provide a digital AM demodulator which is highly reliable, relatively easy to manufacture and at competitive costs.

This aim, these objects and others which will become apparent hereinafter are achieved by a digital AM demodulator according to claim 1.

Further characteristics and advantages of the invention will become apparent from the description of preferred but not exclusive embodiments of the demodulator according to the invention, illustrated by way of non-limitative example in the accompanying drawings, wherein:

Figure 1 is a block diagram of direct AM demodulation;

Figure 2 is a block diagram of two-step AM demodulation;

Figures 3 and 4 are charts which plot direct analog demodulation with the local carrier arranged respectively in two different positions;

Figure 5a is a chart which plots direct digital demodulation;

Figure 5b is a chart which plots direct digital demodulation with aliasing;

Figure 5c is a chart which plots indirect digital demodulation without aliasing;

Figure 6 is a block diagram of a one-step digital demodulator according to the present invention;

Figure 7 is a block diagram of a two-step digital demodulator according to the present invention;

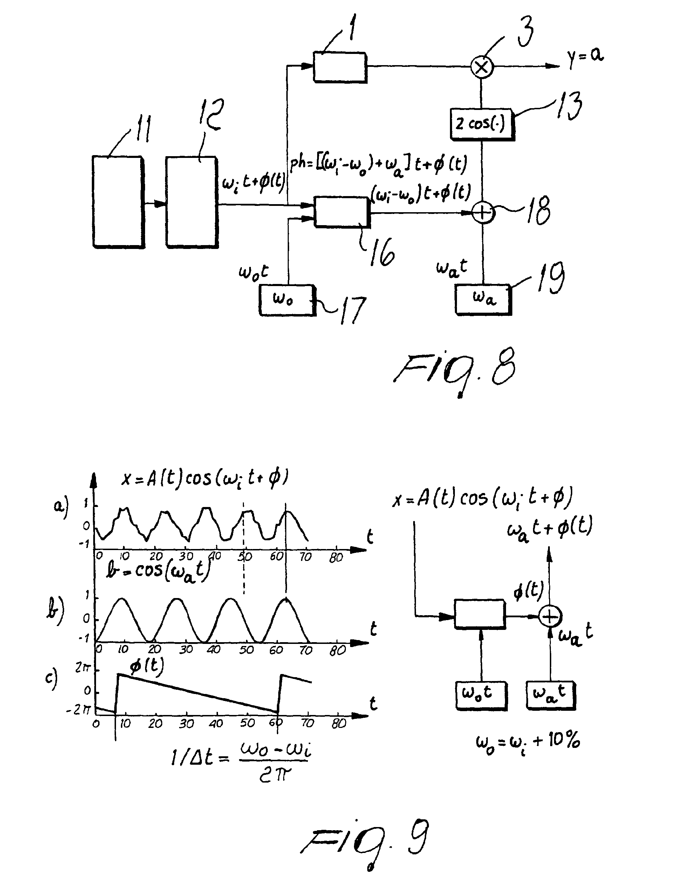

Figure 8 is a block diagram of an equivalent phase recovery circuit used in the digital demodulator shown in Figures 6 and 7; and

Figure 9 is a chart which plots the signals that contribute to the determination of the correction phase in the digital demodulator according to the present invention.

With reference to the above figures, in which identical reference numerals designate identical elements, the digital demodulator according to the present invention is shown in its first embodiment in Figure 6, in which the block designated by the reference numeral 10 corresponds to the block designated by the reference numeral 10 shown in Figure 1.

The signal arriving from a tuner 11 is sampled in an analog/digital converter 12 and is then fed to the block 10, which comprises an input filter 1, multiplier means 3, a low-pass filter 2; in said block, the multiplier means 3 multiply the signal in output from the low-pass filter 1 by a carrier indicated by the block 13.

The block 10 therefore comprises at least one means for generating a carrier. The digital demodulator according to the invention further comprises means for detecting the phase shift between the pulse of an input signal x (input) which arrives from the analog/digital converter 12 and is fed to the filter 1 and a local carrier designated by $\omega_o t$.

The carrier generation means 13 generate a carrier, designated by *carrier,* which is phase-correlated with respect to the phase $\phi$ of the signal received by the tuner 11.

The local carrier generated by the local carrier generation means 17 is not correlated with the carrier of the input signal x.

The means 15 for detecting the phase shift between the pulse of the input signal and the local carrier further comprise means for correlation between the local carrier $\omega_o t$ and the first carrier $\omega_a t$.

In detail, the means for detecting the phase shift between the pulse of the input signal and the local carrier comprise means 16 adapted to provide in output an estimated phase error signal $\phi(t)$ which is determined by means of a comparison between the phase of the input signal (x = input) and the phase of the local carrier $\omega_o t$.

Said phase error signal $\phi(t)$ is fed to adder means 18 which constitute means for correlation between the first carrier $\omega_a t$ and the pulse of the input signal x. The means for generating the first carrier 19 therefore generate the carrier $\omega_a t$, which is fed to the adder means 18 together with the phase error signal $\phi(t)$, and the output signal of the adder means 18 is sent to the carrier generation means proper 13, which are connected to the multiplier means 3.

The block diagram of Figure 6, which illustrates the structure of the one-step digital demodulator according to the present invention, is based on the assumption that the pulse of the local carrier $\omega_o$ is equal to the pulse $\omega_a$ of the first carrier and that the pulse of the local carrier is proximate to the pulse $\omega_i$ of the input signal.

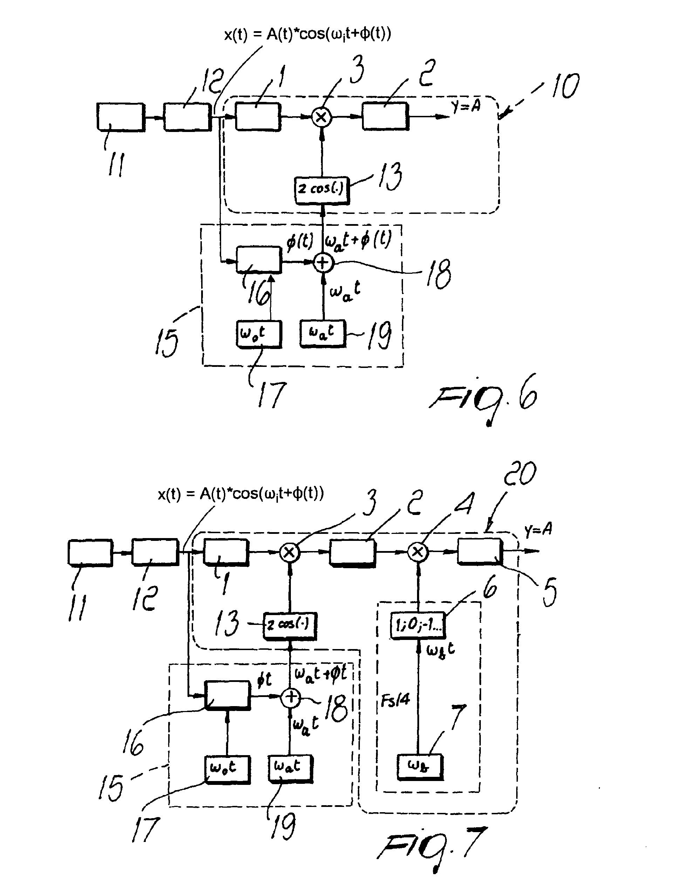

Figure 7 illustrates a second embodiment of the digital demodulator, in this case of the two-step type, according to the present invention.

In this case it is necessary to have $\omega_o = \omega_a + \omega_b$; $\omega_o$ must be in the neighborhood of $\omega_i$.

Reference should be made again to Figure 2, which is a block diagram of two-step AM demodulation.

The demodulator according to the invention starts from the block diagram of Figure 2, which includes an input filter 1, a second low-pass filter, first multiplier means 3 which are interposed between said two filters, a second multiplier 4 which is cascade-connected to the low-pass filter 2 and receives in input a second carrier, and finally a low-pass filter 5 which is cascade-connected to the second multiplier means 4.

Therefore the block designated by 20 in Figure 7 substantially corresponds to the block designated by the reference numeral 20 in Figure 2, with the differences presented hereinafter.

The block designated by the reference numeral 15 of Figure 7 instead exactly corresponds to the block designated by the reference numeral 15 in Figure 6.

The particularity of the circuit of Figure 7, in addition to the fact of having two carriers, both of which are not phase-correlated with respect to the phase $\varphi$ of the signal received by the tuner 11, and two multiplier means 3 and 4 arranged in a cascade configuration, is the fact that the pulse $\omega_b$ from the second carrier, generated in the block 7, is set equal to the sampling pulse/4 and is correlated to the local carrier $\omega_0 t$ but is not correlated with respect to the phase of the input signal.

The choice made for the pulse $\omega_b$ allows to simplify the hardware complexity of the second multiplier means 4 to a single (N)-bit adder, as described hereinafter.

The block 7, together with the block 6, constitutes a numeric oscillator for generating the second carrier $\omega_b = (\omega_{sampling}/4)$.

Accordingly with reference to Figure 7, the relations that define the signals present in the demodulator of Figure 7 are described hereafter.

$$\text{input} = A(t) \cdot cos(\omega_i t + \phi)$$

$$\text{carrier}_1 = 2 \cdot cos[(\omega_i - \omega_a)t + \phi]$$

$$\text{carrier}_2 = 2 \cdot cos(\omega_a t)$$

$$t = n/Ts$$

$$\omega_b = (\omega_{sampling})/4 \text{ and } \omega_a = \omega_i - (\omega_{sampling})/4$$

$$y_a = \text{input} \cdot \text{carrier}_1$$

$$y_a = 2 \cdot A(t) \cdot cos(\omega_i t + \phi) \cdot cos[(\omega_i - \omega_a)t + \phi]$$

$$= A(t)\{cos(\omega_a t) + cos (2 \cdot \omega_i - \omega_a)t + 2 \cdot \phi\}$$

After the first filter 1 one obtains:

$$y_b = A(t) \cdot cos(\omega_a t)$$

$$y = 2 \cdot A(t) \cdot cos(\omega_a t) \cdot cos(\omega_a t) = A(t)[cos(2 \cdot \omega_a t) + cos(\omega_a t - \omega_a t)]$$

Finally, after the second low-pass filter 5 one obtains:

$$y = A(t) \cdot cos(\omega_a t - \omega_a t) = A(t)$$

As mentioned, the choice made for the second carrier $\omega_b$ allows to simplify the hardware complexity of the second multiplier means 4, reducing them to a single N-bit adder, since:

$$cos(\omega_b t) = cos(2\pi \cdot n \cdot \omega_b/\omega_{sampling}) = cos(n \cdot \pi/2) = \{1,0,-1,0,1 \; ...\}$$

whereas a full multiplier is formed by (N-1) N-bit adders.

The digital demodulator according to the invention therefore substantially comprises a section formed by the cascade arrangement of a full multiplier (first multiplier means 3), a simplified multiplier (second multiplier means 4), a numeric oscillator 6, 7 for generating the second carrier $\omega_b = (\omega_{sampling})/4$ and the appropriate filters 1, 2 and 5 in order to eliminate the unwanted spectral repeats as mentioned earlier.

The second section, designated by the reference numeral 15, is instead formed by a system for generating the first carrier $\omega_a$ and the recovery of the phase $\varphi$ of the spectrum of the received signal without the aid of a PLL which causes integration and cost problems.

Figure 9 illustrates the equivalent phase recovery circuit, which takes into account any jittering of the tuner 11.

It is assumed initially that the local carrier $\omega_o t$ coincides with the carrier $\omega_i t$ of the tuner 11. In this case, the block 16 returns in output the estimated phase error $\phi$. If this value is added to the first carrier $\omega_a t$, which is not correlated with the input, one obtains

$$\omega_a t + \phi = (\omega_i - \omega_a/4)t + \phi$$

which is exactly the pulse of the first carrier that was to be obtained. We now analyze the case in which the carrier at the output of the tuner 11 varies with respect to its nominal value (jitter):

$$\omega_i = (\omega_i + \Delta\omega)t,$$

the final pulse is:

$$ph = [(\omega_i - \omega_o) + \omega_a]t + \phi$$

and once again the second term is the phase shift to be obtained, while the first term is

$$\omega = d[(\omega_i - \omega_o) + \omega_a]t/dt = (\omega_i - \omega_o) + \omega_a = \Delta\omega + \omega_a$$

the pulse of the first carrier corrected with the term $\Delta\omega$ in order to compensate for the variation of the tuner 11.

Figure 9 illustrates, by way of example, the situation that occurs if $\omega_i$ and $\omega_o$ differ by 10%. Chart (a) shows the received signal, which is amplitude-modulated with the transmitted carrier. Chart (b) plots the local carrier $\omega_o$, whose pulse is smaller than $\omega_i$ and chart (c) plots the phase $\phi(t)$ for carrier recovery.

It should be noted that $1/\Delta t$ is exactly $\Delta\omega/2\pi$, i.e., the correction of the pulse to be applied.

The demodulator according to the invention therefore proposes two alternative structures (in the case of a single-step or two-step digital modulator) which are efficient in terms of complexity (reduced occupied area) and which, with an appropriate distribution of the involved parameters, allow to obtain structurally simple blocks which are not affected by the typical drawbacks of an integrated PLL (rounding and quantization error).

In practice it has been observed that the demodulator according to the present invention fully achieves the intended aim and objects, in which carrier phase and frequency recovery is performed without resorting to a PLL, avoiding locking problems, systematic offset integration errors, and errors in truncation of the internal calculation arithmetics.

The demodulator according to the invention allows to provide, with a digital system, both the data processing part and the medium-frequency receiver part directly at the output of the cable, antenna or dish tuner, according to the situation.

The demodulator, in the case of TV use, can also be used for any TV standard.

The demodulator thus conceived is susceptible of numerous modifications and variations, all of which are within the scope of the inventive concept; all the details may also be replaced with other technically equivalent elements.

Where technical features mentioned in any claim are followed by reference signs, those reference signs have been included for the sole purpose of increasing the intelligibility of the claims and accordingly such reference signs do not have any limiting effect on the interpretation of each element identified by way of example by such reference signs.

**Claims**

1. A digital AM demodulator, particularly for demodulating an input signal (x(t) originating from a tuner (11), comprising:

    means (19) for generating a first carrier ($\omega_a$t) which is not phase-correlated with the input signal (x(t) to be demodulated;
    first means (3) for multiplying a demodulating carrier by the input signal (x(t)) to be demodulated;
    first and second filtering means (1,2), arranged upstream and downstream of said multiplier means (3) and adapted to eliminate unwanted spectral repeats;

    **characterized in that** the demodulator comprises means (17) generating a local carrier ($\omega_0$t), means for detecting the phase shift between the pulse of the input signal (x(t) to be demodulated and said local carrier ($\omega_0$t) and generating a phase error signal $\phi$(t), means (18) for correlating by means of said phase error $\phi$(t), the pulse of said first carrier ($\omega_a$t) with said input signal (x(t), said first carrier ($\omega_a$t) and said local carrier ($\omega_0$t) being mutually correlated, said local carrier ($\omega_0$t) not being phase-correlated with the input signal (x(t)) to be demodulated and means (13) for generating the demodulating carrier based on the output of said correlating means (18).

2. The demodulator according to claim 1, **characterized in that** it comprises means (7) for generating a second carrier ($\omega_b$t) and second means (4) for multiplying said second carrier ($\omega_b$t) by the signal produced by multiplying and filtering said demodulating carrier by the input signal (x(t)) to be demodulated.

3. The demodulator according to claim 1, **characterized in that** said means (16) for detecting the phase shift between the pulse of the input signal (x(t)) to be demodulated and the local carrier ($\omega_0$t) comprise comparator means (16) adapted to determine a phase error ($\phi$(t)) and receive in input said input signal (x(t)) to be demodulated and said local carrier ($\omega_0$t) generated by local carrier generation means (17).

4. The demodulator according to claim 3, **characterized in that** said means for correlating said first carrier with said input signal comprise adder means (18) which are suitable to add said phase error emitted by said comparator means (16) to the pulse of said local carrier ($\omega_0$t) in order to send the sum signal to the demodulating carrier generation means (13).

5. The demodulator according to claim 1, **characterized in that** the pulse of said local carrier ($\omega_0$t) is equal to the pulse of said first carrier ($\omega_a$t).

6. The demodulator according to claim 5, **characterized in that** the pulse of said local carrier ($\omega_0$t) is in the neighborhood of the pulse of said input signal (x(t)) to be demodulated.

7. The demodulator according to claim 1, **characterized in that** said first multiplier means (3) comprise a full multiplier.

8. The demodulator according to claim 2, **characterized in that** said second carrier ($\omega_b$t) has a pulse which is equal to one quarter of a sampling pulse used for A/D conversion of the input signal x(t).

9. The demodulator according to claim 8, **characterized in that** said second multiplier means (4) comprise an N-bit adder.

**10.** The demodulator according to claim 2, **characterized in that** said means (7) for generating the second carrier ($\omega_b t$) comprise a numeric oscillator.

**11.** The demodulator according to claim 8, **characterized in that** the pulse of said first carrier ($\omega_a t$) is equal to the difference between the pulse of said input signal (x(t)) to be demodulated and the pulse of said second carrier ($\omega_b t$).

**12.** The demodulator according to claim 2, **characterized in that** it comprises third filter means (20) arranged downstream of said second multiplier means (4).

**13.** A method for the digital AM demodulation of an input signal (x(t)) from a tuner (11), comprising the steps of:

multiplying the input signal (x(t)) to be demodulated by at least one demodulating carrier and filtering, before and after said multiplication, respectively said input signal (x(t)) and the signal produced by said multiplication, **characterized in that** it further comprises the steps of:

generating a first carrier ($\omega_a t$), which is not phase-correlated with the input signal x(t);
determining a phase shift between the pulse of the input signal (x(t)) to be demodulated and the pulse of a local carrier, generating a phase error signal ($\phi(t)$);
correlating, by means of said phase error signal ($\phi(t)$), the pulse of said first carrier ($\omega_a t$) with the pulse of the input signal (x(t)) to be demodulated; and
generating, based on the correlated pulse of said first carrier ($\omega_a t$), a demodulating carrier which is correlated with said input signal (x(t)) and is adapted to be multiplied by said input signal.

**14.** The method according to claim 13, **characterized in that** it further comprises the steps of generating a second carrier ($\omega_b t$) and multiplying said second carrier by the signal obtained by multiplying said input signal and said demodulating carrier.

**15.** The method according to claim 13, **characterized in that** said step that consists in correlating said first carrier ($\omega_a t$) with said input signal (x(t)) consists in adding said error signal ($\phi(t)$) to the pulse of said first carrier.

**16.** The method according to claim 13, **characterized in that** the pulse of said local carrier ($\omega_b t$) is chosen close to the pulse of said input signal (x(t)) and equal to the pulse of said first carrier ($\omega_a t$).

**17.** The method according to claim 14, **characterized in that** the pulse of said second carrier ($\omega_b t$) is chosen equal to one quarter of the A/D converter sampling pulse of said input signal (x(t)) and the pulse of said first carrier ($\omega_a t$) is chosen equal to the difference between the pulse of the input signal (x(t)) to be demodulated and the pulse of said second carrier ($\omega_b t$).

**18.** A television receiver comprising a tuner (11), an analog/digital converter (12) and a demodulator according to claim 1. ($\omega_0 t$) (c)

**Patentansprüche**

**1.** Digitaler AM-Demodulator, insbesondere zum Demodulieren eines Eingangssignals (x(t)), welches aus einem Tuner (11) stammt, umfassend:

Mittel (19) zum Erzeugen einer ersten Trägerwelle ($\omega_a t$), welche nicht Phasen-korreliert mit dem Eingangssignal (x(t)) ist, welches zu demodulieren ist;
erste Mittel (3) zum Multiplizieren einer Demoludationsträgerwelle mit dem Eingangssignal (x(t)), welches zu demodulierenden ist;
erste und zweite Filtermittel (1,2), welche vor und hinter den Multiplikationsmitteln (3) angeordnet sind und ausgebildet sind, um unerwünschte spektrale Wiederholungen zu eliminieren;

**dadurch gekennzeichnet, dass** der Demodulator Mittel (17) zum Erzeugen einer lokalen Trägerwelle ($\omega_0 t$), Mittel zum Detektieren des Phasenversatzes zwischen dem Puls des Eingangssignals (x(t)), welches zu demodulieren ist, und der lokalen Trägerwelle ($\omega_0 t$) umfasst und zum Erzeugen eines Phasenfehlersignals $\phi(t)$ und weiterhin Mittel (18) zum Korrelieren anhand des Phasenfehlers $\phi(t)$ den Puls der ersten Trägerwelle ($\omega_a t$) mit dem Eingangssignal

(x(t)) umfasst, wobei die erste Trägerwelle ($\omega_a$t) und die lokale Trägerwelle ($\omega_0$t) gegeneinander korreliert sind und die lokale Trägerwelle ($\omega_0$t) nicht Phasen-korreliert mit dem Eingangssignal (x(t)), welches zu demodulieren ist, ist und weiterhin umfassend Mittel (13) zum Erzeugen der Demoludationsträgerwelle basierend auf dem Ausgang der Korrelationsmittel (18).

2. Demodulator nach Anspruch 1, **dadurch gekennzeichnet, dass** er Mittel (7) zum Erzeugen einer zweiten Träger- welle ($\omega_b$t) und zweite Mittel (4) zum Multiplizieren der zweiten Trägerwelle ($\omega_b$t) mit dem Signal, welches durch die Multiplikation und Filterung der Demoludationsträgerwelle mit dem Eingangssignal (x(t)), welches zu demodulieren ist, erzeugt wurde, umfasst.

3. Demodulator nach Anspruch 1, **dadurch gekennzeichnet, dass** die Mittel (16) zum Detektieren des Phasenversatzes zwischen dem Puls des Eingangssignals (x(t)), welches zu demodulieren ist, und der lokalen Trägerwelle ($\omega_0$t) Komparatormittel (16) umfassen, welche ausgebildet sind, um einen Phasenfehler $\phi$(t) zu bestimmen und um als Eingang das Eingangssignal (x(t)), welches zu demodulieren ist, und die lokale Trägerwelle ($\omega_0$t), die durch die lokalen Trägererzeugungsmittel (17) erzeugt wird, zu empfangen.

4. Demodulator nach Anspruch 3, **dadurch gekennzeichnet, dass** die Mittel zum Korrelieren der ersten Trägerwelle mit dem Eingangssignal Additionsmittel (18) umfassen, welche ausgebildet sind, um den Phasenfehler, der durch die Komparatormittel (16) ausgegeben wird, zu dem Puls der lokalen Trägerwelle ($\omega_0$t) zu addieren, um das Summensignal zu den Demodulationsträgerwellenerzeugungsmitteln (13) zu senden.

5. Demodulator nach Anspruch 1, **dadurch gekennzeichnet, dass** der Puls der lokalen Trägerwelle ($\omega_0$t) dem Puls der ersten Trägerwelle ($\omega_a$t) entspricht.

6. Demodulator nach Anspruch 5, **dadurch gekennzeichnet, dass** der Puls der lokalen Trägerwelle ($\omega_0$t) benachbart zum Puls des Eingangssignals (x(t)), welches zu demodulieren ist, liegt.

7. Demodulator nach Anspruch 1, **dadurch gekennzeichnet, dass** die ersten Multiplikationsmittel (3) einen vollständigen Multiplizierer umfassen.

8. Demodulator nach Anspruch 2, **dadurch gekennzeichnet, dass** der zweite Träger ($\omega_b$t) einen Puls aufweist, welcher einem Viertel eines Abtastpulses, der für die A/D-Wandlung des Eingangssignals (x(t)) verwendet wird, entspricht.

9. Demodulator nach Anspruch 8, **dadurch gekennzeichnet, dass** die zweiten Multiplikationsmittel (4) einen N-Bit- Addierer umfassen.

10. Demodulator nach Anspruch 2, **dadurch gekennzeichnet, dass** die Mittel (7) zum Erzeugen der zweiten Träger- welle ($\omega_b$t) einen numerischen Oszillator umfassen.

11. Demodulator nach Anspruch 8, **dadurch gekennzeichnet, dass** der Puls der ersten Trägerwelle ($\omega_a$t) der Differenz zwischen dem Puls des Eingangssignals (x(t)), welches zu demodulieren ist, und dem Puls der zweiten Trägerwelle ($\omega_b$t) entspricht.

12. Demodulator nach Anspruch 2, **dadurch gekennzeichnet, dass** er weiterhin dritte Filtermittel (20) umfasst, die hinter den zweiten Multiplikationsmitteln (4) angeordnet sind.

13. Verfahren zur digitalen AM-Demodulation eines Eingangssignals (x(t)) von einem Tuner (11), umfassend die Schritte:

Multiplizieren des Eingangssignals (x(t)), welches zu demodulieren ist, mit wenigstens einer Demodulationsträgerwelle und Filtern, vor und nach der Multiplikation, entsprechend des Eingangssignals (x(t)) und des Signals, welches durch die Multiplikation erzeugt wurde, **dadurch gekennzeichnet, dass** es weiter die Schritte umfasst:

Erzeugen einer ersten Trägerwelle ($\omega_a$t), die nicht Phasen-korreliert mit dem Eingangssignal (x(t)) ist;
Bestimmen eines Phasenversatzes zwischen dem Puls des Eingangssignals (x(t)), welches zu demodulieren ist, und dem Puls einer lokalen Trägerwelle, Erzeugen eines Phasenfehlersignals ($\phi$(t));
Korrelieren, mittels des Phasenfehlersignals ($\phi$(t)), den Puls des ersten Trägers ($\omega_a$t) mit dem Puls des Eingangssignals (x(t)), welches zu demodulieren ist; und
Erzeugen, basierend auf dem korrelierten Puls der ersten Trägerwelle ($\omega_a$t), eine Demodulationsträgerwelle,

welche mit dem Eingangssignal (x(t)) korreliert ist und ausgebildet ist, um mit dem Eingangssignal multipliziert zu werden.

14. Verfahren nach Anspruch 13, **dadurch gekennzeichnet, dass** es weiterhin die Schritte umfasst:

Erzeugen einer zweiten Trägerwelle ($\omega_b$t) und Multiplizieren der zweiten Trägerwelle mit dem Signal, welches durch Multiplikation des Eingangssignals und der Demoludationsträgerwelle erhalten wurde.

15. Verfahren nach Anspruch 13, **dadurch gekennzeichnet, dass** der Schritt, der im Korrelieren der ersten Trägerwelle ($\omega_a$t) mit dem Eingangssignal (x (t)) besteht, im Addieren des Fehlersignals ($\phi$(t)) zu dem Puls der ersten Trägerwelle besteht.

16. Verfahren nach Anspruch 13, **dadurch gekennzeichnet, dass** der Puls der lokalen Trägerwelle ($\omega_b$t) nahe zu dem Puls des Eingangssignals (x(t)) und gleich dem Puls der ersten Trägerwelle ($\omega_a$t) gewählt wird.

17. Verfahren nach Anspruch 14, **dadurch gekennzeichnet, dass** der Puls der zweiten Trägerwelle ($\omega_b$t) gleich einem Viertel des Abtastpulses des A/D-Wandlers des Eingangssignals (x(t)) gewählt wird, und dass der Puls der ersten Trägerwelle ($\omega_a$t) gleich der Differenz zwischen dem Puls des Eingangssignals (x(t)), welches zu demodulieren ist, und dem Puls der zweiten Trägerwelle ($\omega_b$t) gewählt wird.

18. Fernsehempfänger, umfassend einen Tuner (11), einen Analog-/Digitalwandler (12) und einen Demodulator nach Anspruch 1.

**Revendications**

1. Démodulateur numérique à modulation d'amplitude, en particulier pour démoduler un signal d'entrée (x(t)) provenant d'un syntoniseur (11), comprenant :

des moyens (19) pour produire une première porteuse ($\omega_a$t) qui n'est pas corrélée en phase avec le signal d'entrée (x(t))à démoduler ;
des premiers moyens (3) pour multiplier une porteuse de démodulation par le signal d'entrée (x(t)) à démoduler ;
des premier et second moyens de filtrage (1, 2) disposés en amont et en aval des moyens multiplieurs (3) et adaptés à éliminer des répétitions spectrales indésirées ;

**caractérisé en ce que** le démodulateur comprend des moyens (17) produisant une porteuse locale ($\omega_0$t) pour détecter le déphasage entre l'impulsion du signal d'entrée (x(t)) à démoduler et la porteuse locale ($\omega_0$t) et produisant un signal d'erreur de phase $\phi$(t) et des moyens (18) pour corréler au moyen de l'erreur de phase $\phi$(t) l'impulsion de la première porteuse ($\omega_a$t) avec le signal d'entrée (x(t)), la première porteuse ($\omega_a$t) et la porteuse locale ($\omega_0$t) étant mutuellement corrélées, la porteuse locale ($\omega_0$t) n'étant pas corrélée en phase avec le signal d'entrée (x(t)) à démoduler, et des moyens (13) pour produire la porteuse de démodulation sur la base de la sortie des moyens de corrélation (18).

2. Démodulateur selon la revendication 1, **caractérisé en ce qu'**il comprend des moyens (7) pour produire une seconde porteuse ($\omega_b$t) et des seconds moyens (4) pour multiplier la seconde porteuse ($\omega_b$t) par le signal produit en multipliant et en filtrant la porteuse de démodulation par le signal d'entrée (x(t)) à démoduler.

3. Démodulateur selon la revendication 1, **caractérisé en ce que** les moyens (16) pour détecter le déphasage entre l'impulsion du signal d'entrée (x(t)) à démoduler et la porteuse locale ($\omega_0$t) comprennent des moyens comparateurs (16) adaptés à déterminer une erreur de phase ($\phi$(t)) et à recevoir le signal d'entrée (x(t)) à démoduler et la porteuse locale ($\omega_0$t) produite par des moyens (17) de génération de porteuse locale.

4. Démodulateur selon la revendication 3, **caractérisé en ce que** les moyens pour corréler la première porteuse avec le signal d'entrée comprennent des moyens additionneurs (18) qui sont aptes à ajouter l'erreur de phase émise par les moyens comparateurs (16) à l'impulsion de la porteuse locale ($\omega_0$t) pour envoyer le signal somme aux moyens de génération de porteuse de démodulation (13).

5. Démodulateur selon la revendication 1, **caractérisé en ce que** l'impulsion de la porteuse locale ($\omega_0$t) est égale à

l'impulsion de la première porteuse ($\omega_a$t).

6. Démodulateur selon la revendication 5, **caractérisée en ce que** l'impulsion de la porteuse locale ($\omega_0$t) est au voisinage de l'impulsion du signal d'entrée (x(t)) à démoduler.

7. Démodulateur selon la revendication 1, **caractérisé en ce que** les premiers moyens multiplieurs (3) comprennent un multiplieur complet.

8. Démodulateur selon la revendication 2, **caractérisé en ce que** la seconde porteuse ($\omega_b$t) a une impulsion qui est égale au quart d'une impulsion d'échantillonnage utilisée pour la conversion analogique-numérique du signal d'entrée (x(t)).

9. Démodulateur selon la revendication 8, **caractérisé en ce que** les seconds moyens multiplieurs (4) comprennent un additionneur à N bits.

10. Démodulateur selon la revendication 2, **caractérisé en ce que** les moyens (7) pour produire la seconde porteuse ($\omega_b$t) comprennent un oscillateur numérique.

11. Démodulateur selon la revendication 8, **caractérisé en ce que** l'impulsion de la première porteuse ($\omega_a$t) est égale à la différence entre l'impulsion du signal d'entrée (x(t)) à démoduler et l'impulsion de la seconde porteuse ($\omega_b$t).

12. Démodulateur selon la revendication 2, **caractérisé en ce qu'**il comprend des troisièmes moyens de filtre (20) agencés en aval des seconds moyens multiplieurs (4).

13. Procédé pour la démodulation d'amplitude numérique d'un signal d'entrée (x(t)) à partir d'un syntoniseur (11), comprenant les étapes suivantes :

multiplier le signal d'entrée (x(t)) à démoduler par au moins une porteuse de démodulation et filtrer, avant et après la multiplication, respectivement le signal d'entrée (x(t)) et le signal produit par la multiplication, **caractérisé en ce qu'**il comprend en outre les étapes suivantes :

produire une première porteuse ($\omega_a$t) non corrélée en phase avec le signal d'entrée (x(t)) ;
déterminer un déphasage entre l'impulsion du signal d'entrée (x(t)) à démoduler et l'impulsion d'une porteuse locale, produisant un signal d'erreur de phase ($\phi$(t)) ;
corréler au moyen du signal d'erreur de phase ($\phi$(t)) l'impulsion de la première porteuse ($\omega_a$t) avec l'impulsion du signal d'entrée (x(t)) à démoduler ; et
produire, sur la base de l'impulsion corrélée de la première porteuse ($\omega_a$t), une porteuse de démodulation corrélée avec le signal d'entrée (x(t)) et adaptée à être multipliée par le signal d'entrée.

14. Procédé de la revendication 13, **caractérisé en ce qu'**il comprend en outre les étapes consistant à produire une seconde porteuse ($\omega_b$t) et à multiplier la seconde porteuse par le signal obtenu en multipliant le signal d'entrée et la porteuse de démodulation.

15. Procédé de la revendication 13, **caractérisé en ce que** l'étape qui consiste à corréler la première porteuse ($\omega_a$t) avec le signal d'entrée (x(t)) consiste à ajouter le signal d'erreur ($\phi$(t)) à l'impulsion de la première porteuse.

16. Procédé de la revendication 13, **caractérisé en ce que** l'impulsion de la porteuse locale ($\omega_b$t) est choisie proche de l'impulsion du signal d'entrée (x(t)) et égale à l'impulsion de la première porteuse ($\omega_a$t).

17. Procédé selon la revendication 14, **caractérisé en ce que** l'impulsion de la seconde porteuse ($\omega_b$t) est choisie égale au quart de l'impulsion d'échantillonnage du convertisseur analogique-numérique du signal d'entrée (x(t)) et l'impulsion de la première porteuse ($\omega_a$t) est choisie égale à la différence entre l'impulsion du signal d'entrée (x(t)) à démoduler et l'impulsion de la seconde porteuse ($\omega_b$t).

18. Récepteur de télévision comprenant un syntoniseur (11), un convertisseur analogique-numérique (12) et un démodulateur selon la revendication 1.

*10*

*3* $Y_1$ *2*

$x = A(t)\cos(\omega_i\,t+\phi)$

*1*

$2\cos(\omega_a t+\psi)$

$y = A$

Fig. 1

*1 3* $Y_a$ *2* $Y_b$ *4 5*

$x = A(t)\cos(\omega_i\,t+\phi)$

*20*

$2\cos(\omega_a t+\psi)$  $2\cos(\omega_b t+\varphi)$

$y = A$

Fig. 2

INPUT CHANNEL

A

B

$f_i$  $f_h$  $f$

LOCAL CARRIER

$f$

DEMODULATOR $f_c$

$f$

B  A

$f$

LP FILTERING

A

B

$f$

Fig. 3

Fig.4

INPUT CHANNEL

NYQUIST

NYQUIST

Fig.5a

INPUT CHANNEL

Fig.5c

NYQUIST

Fig.5b

$x(t) = A(t)^{*}\cos(\omega_i t + \phi(t))$

*Fig.6*

$x(t) = A(t)^{*}\cos(\omega_i t + \phi(t))$

*Fig.7*

$ph = [(\omega_i - \omega_o) + \omega_a] t + \phi(t)$

$(\omega_i - \omega_o) t + \phi(t)$

$y = a$

$2\cos(\cdot)$

$\omega_i t + \phi(t)$

$\omega_o t$

$\omega_a t$

$\omega_o$

$\omega_a$

Fig. 8

a) $x = A(t)\cos(\omega_i t + \phi)$

b) $b = \cos(\omega_a t)$

c) $\phi(t)$

$1/\Delta t = \dfrac{\omega_o - \omega_i}{2\pi}$

$x = A(t)\cos(\omega_i t + \phi)$

$\omega_a t + \phi(t)$

$\phi(t)$

$\omega_a t$

$\omega_o t$

$\omega_a t$

$\omega_o = \omega_i + 10\%$

Fig. 9